# EUROPEAN PATENT SPECIFICATION

(11) **EP 3 575 805 B1**
(45) Date of publication and mention of the grant of the patent: **26.01.2022**
(21) Application number: 18305663.9
(22) Date of filing: 30.05.2018
(51) Int. Cl.: G01R 21/00, G01R 19/00

(54) **DC SUBSTATION AND METHOD FOR DETECTING AN ELECTRICAL ENERGY FLOW IN SAID SUBSTATION**
GLEICHSTROMUNTERSTATION UND VERFAHREN ZUR DETEKTION EINES STROMFLUSSES IN DER BESAGTEN UNTERSTATION
SOUS-STATION CC ET PROCÉDÉ POUR DÉTECTER UN FLUX D'ÉNERGIE ÉLECTRIQUE DANS CETTE SOUS-STATION

(43) Date of publication of application: 04.12.2019
(73) Proprietor: ALSTOM Transport Technologies, 93400 Saint-Ouen (FR)
(72) Inventor: SÖFFKER, Carsten, 38321 Denkte (DE); HOFSTÄDTER, Raphael, 38229 Salzgitter (DE)
(74) Representative: Lavoix

(56) References cited:
- JP-A- 2000 092 718
- US-A1- 2010 181 830
- US-A1- 2011 098 952
- US-A1- 2017 040 887
- US-A1- 2017 067 948

## Description

The present invention generally relates to a DC substation and to a method for detecting an electrical energy flow in said DC substation.

In particular the present disclosure relates to a DC substation comprising a first terminal adapted to connect the DC substation to an electrical power grid and a plurality of second terminals adapted to provide or receive DC current to or from a plurality of loads.

In order to measure and control the energy flow, such DC substations comprise a plurality of measurement devices. In general, measurement devices may have a measurement error which results in inaccurate measurement values for the DC substation.

In order to obtain reliable measurement values and to control the energy flow in the DC substation which may, for example, serve for billing purposes, tax refund and other financial transactions, these measurement devices must have a low measurement error. For example, such measurement devices must be calibrated in order to satisfy legal requirements.

However, it is not possible to conduct a DC energy measurement with certified meters, as such DC meters are not available on the market.

US 2014/0333294 A1 discloses a method for determining a power consumption.

US 2017/067948 A1 describes a power monitoring system including a renewable energy source, an energy storage system, a distribution board, a first power metering device, a second power metering device, a third power metering device, a fourth power metering device and a server.

US 2017/040887 A1 describes a DC/AC converter apparatus for converting DC power of a DC energy source into AC power for supplying a load or a utility grid.

Thus, such DC substations are not satisfactory, as they are complex and not easy to control.

An object of the present disclosure is to provide a DC substation which has a simple architecture and which is easy to control at the same time and does comply with legal requirements.

According to one aspect, a DC substation is provided according to claim 1.

Further embodiments may relate to one or more of the features according to claims 2 to 9.

The invention further relates to a method for detecting an energy flow in a DC substation according to claim 10.

According to an advantageous but not mandatory aspect of the invention, such method may comprise the features of claim 11.

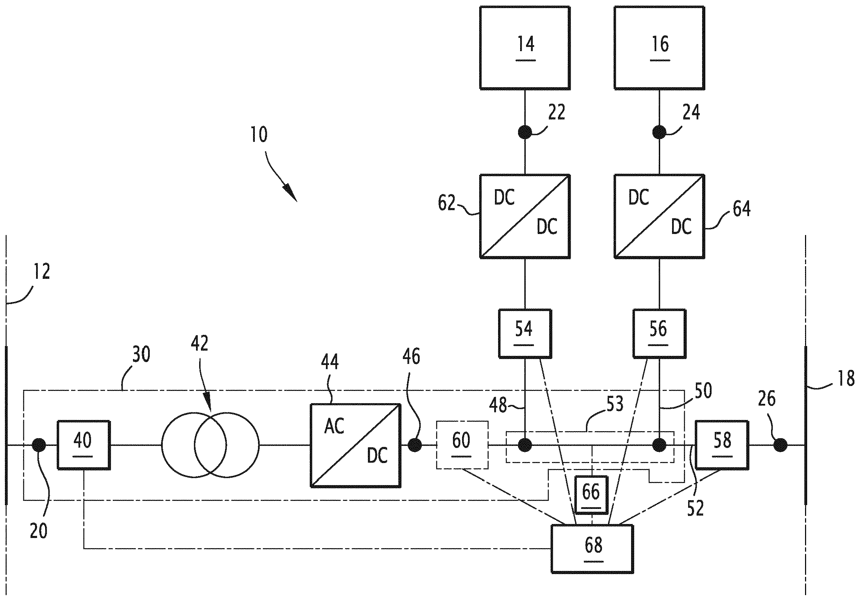

So that the manner in which the above recited features of the present invention can be understood in detail, a more particular description of the invention, briefly summarized above, may be read by reference to embodiments. The accompanying drawing relates to embodiments of the invention and is described in the following.

The Figure is a schematic representation of a DC substation according to the invention.

The Figure shows a DC (direct current) substation 10, an AC (alternating current) electrical power grid 12 and a plurality of DC loads 14, 16, 18.

The DC substation 10 is, for example, a distribution station in an urban environment. In another embodiment the DC substation may be a DC substation for a railway network.

According to one embodiment, the DC substation 10 is provided in order to supply the loads 14, 16, 18 with a direct current or receive a direct current from the loads 14, 16, 18. Furthermore, the DC substation 10 is configured for receiving electrical power from the AC electrical power grid 12 or transmitting electrical power thereto.

The DC substation 10 includes a first terminal 20 or grid connection node adapted to connect the DC substation to the AC electrical power grid 12. The AC electrical power grid 12 is for example a high voltage power grid or medium voltage power grid and connected to electrical energy producing plants. The medium or high voltage power grid may be a three phase or a single phase power grid.

The DC substation 10 further includes a plurality of second terminals 22, 24, 26, in particular at least two second terminals, for example three second terminals 22, 24, 26. Each second terminal 22, 24, 26 is adapted to connect the DC substation 10 respectively to a load 14, 16, 18. According to an embodiment, the load 14, 16, 18 is an electric road vehicle charging station, an energy storage system, a supply conductor for a railway vehicle, or the like. Preferably, each load 14, 16, 18 is of a different type from one another. For example, load 14 is an electric road vehicle charging station, load 16 an energy storage system and load 18 is a supply conductor for a railway vehicle, such as for example a tramway network. According to an embodiment, the load 18 is a supply conductor for an electrical vehicle. The electrical vehicle is for example a metro, tram, light rail, trolley bus, lorry, or the like.

According to other embodiments, the load may be of any other suitable type.

According to embodiments, each load 14, 16, 18 may consume electrical energy assigned with different fees, taxes or the like. In even other embodiments, the electrical energy is even resold to third parties.

The DC substation 10 further comprises a current supply chain 30. According to an embodiment, the current supply chain 30 comprises an AC electricity meter 40, a transformer 42 and AC/DC converter 44 and a branching circuit 53.

The AC electricity meter 40 is provided for measuring an electrical energy. For example, the AC electricity meter 40 measures the electrical energy for time intervals with a sample period t. The time intervals last for example between 1 s and 1 day, in particular 15 minutes. In particular, the time t of the sample period is predefined.

The AC electricity meter 40 is adapted to measure active and reactive energy consumed and fed back at the sample period of the time t. In particular, the AC electricity meter 40 is configured for measuring a current provided from or to the AC electrical power grid. The AC electricity meter 40 is for example electrically connected between the first terminal 20 and the AC/DC converter 44 in particular between the transformer 42 and the first terminal 20.

According to embodiments, the AC electricity meter 40 is certified according to at least one valid norm concerning energy measurement by AC electricity meters.

The transformer 42 is provided to transform at least one first AC current, for example a three phase current, having first voltages into at least one second AC current having second voltages. The transformer 42 is further provided to transform the at least one second AC current into the at least one first AC current. The transformer 42 is, in particular, a bidirectional transformer. According to some embodiments, the second voltages are lower than the first voltages. The first voltage side of the transformer 42 is directed towards the AC electrical power grid 12.

The AC/DC converter 44, having a DC terminal 46, is electrically connected between the transformer 42 and the branching circuit 53. Thus, the AC/DC converter 44 is electrically connected, via the AC electricity meter 40, to the first terminal 20.

The AC/DC converter 44 is for example a bidirectional AC/DC converter converting an alternating current, in particular a three phase alternating current, for example from the transformer 42 and/or from the electrical power grid 12 connected to the first terminal 20 into a direct current intended to be provided to the branching circuit 53.

According to an embodiment, the AC/DC converter 44 is further provided to convert a direct current from the branching circuit 53 into an alternating current, in particular a three phase alternating current.

In some embodiments, the transformer 42 may be omitted in the current supply chain 30. Then, the AC electricity meter 40 is directly connected to the AC/DC converter 44.

The transformer 42 and the AC/DC converter 44 form a rectifier line having an electrical efficiency lower than 100%. Notably due to the transformation by the transformer 42 and the conversion by the converter 44, electrical energy is dissipated into thermal energy. The dissipated energy is designated as electrical losses in the following.

The branching circuit 53 is connected to the DC terminal 46 of the AC/DC converter 44. The branching circuit 53 provides respectively one branch 48, 50, 52 to a second terminal 22, 24, 26.

According to one embodiment, the branching circuit 53 is formed by a busbar from which the respective branches 48, 50, 52 extend. The busbar 53 is for example an electrically conducting connector.

According embodiments, the branching circuit 53 may comprise N branches, where N is any integer strictly greater than 1. For example, the branching circuit 53 includes at least two, in particular at least three branches 48, 50, 52.

According to one embodiment, each branch 48, 50, 52 comprises a determination device 54, 56, 58 configured for determining a direct current in the respective branch 48, 50, 52 provided to the respective second terminal 22, 24, 26, notably with a predefined sampling frequency. For example, the determination device 54, 56, 58 has a sampling frequency f. The sampling frequency f is between 1 Hz and 10 kHz, in particular between 10 Hz and 500 Hz.

The determination device 54 is provided to determine the direct current in branch 48, the determination device 56 the direct current in branch 50 and the determination device 58 the direct current in branch 52.

According to another embodiment, the branching circuit 53 comprises a determination device 60 provided to measure the current between the branching circuit 53 and the AC/DC converter 44, for example at the DC terminal 46, and the determination devices 48, 50, 52 provided in each branch except one. As represented schematically in the figure, the determination device 60 comprises a DC meter electrically connected to the DC terminal 46 of the AC/DC converter 44 and to the busbar.

In one embodiment, the determination device 54 is provided in branch 48, another determination device 56 is provided in branch 50 and the determination device 60 is provided in an electrical connection between the branching circuit 53 and the AC/DC converter 44, in absence of a determination device in the branch 52. According to other embodiments, the determination device may be omitted alternatively in branch 48 or in branch 50.

At least one determination device 54, 56, 58 comprises, according to one embodiment, a DC meter electrically connected to the respective branch 48, 50, 52. The DC meter is configured for measuring the direct current provided to the respective branch 48, 50, 52. According to embodiments, the determination devices 54, 56, 58, 60 are not certified.

The determination devices 54, 56, 58 are adapted to measure the direct current in each respective branch, in particular the DC current between the branching circuit and the second terminal 22, 24, 26 of the respective branch 48, 50, 52. In particular, the determination device 54 is adapted to measure the direct current at the branch 48 between the branching circuit 53 and the second terminal 22, the determination device 56 is adapted to measure the direct current at the branch 50 between the branching circuit 53 and the second terminal 24 and determination device 58 is adapted to measure the direct current at the branch 52 between the branching circuit 53 and the second terminal 26. In other words, between the determination devices 54, 56, 58 and the branching circuit no further active or passive electrical devices are arranged, which may generate losses, which may reduce the accuracy of the measurements.

The determination device 60 is adapted to measure the direct current between the DC terminal 46 and the branching circuit 53. or to the terminal (46) within the current supply chain (30)

In some embodiments, some of the branches 48, 50, 52 comprise respectively a DC/DC converter 62, 64. According to one embodiment, a DC/DC converter 62 is provided in branch 48 and a DC/DC converter 64 is provided in branch 50. According to this embodiment, no DC/DC converter is provided in branch 52. Any other technical feasible arrangement of DC/DC converters 62, 64 in the branches 48, 50, 52 may be chosen.

According to another embodiment, at least one determination device 54, 56, 58 is using one or more state variables from a control system (not represented in the figure), notably distinct from the DC substation 10, for determining in particular the current in the respective branch 48, 50, 52. By "state variable", it is understood a control variable of a different or second control system (not represented in the figure), distinct from the DC substation 10. Such variables are used to control the DC/DC converters 62, 64 in order to generate the desired current in the branches 48, 50. They are computed based on other data of the system, for example the state of charge of the energy storage system 16 or the demand of the vehicle charging station 14. The DC/DC converter 48, 50 electrically connects the branching circuit 53 or the busbar in each branch 48, 50 with the respective second terminal 22, 24. Each DC/DC converter 62, 64 is for example a bidirectional converter converting a direct current having a third voltage into a direct current having a fourth voltage different from the third voltage and vice versa. The third voltage side of the DC/DC converter 62, 64 is directed towards the busbar and the fourth voltage side of the DC/DC converter 62, 64 is directed towards the second terminal 22, 24.

Further, the DC substation 10 includes a voltage meter 66 for determining the voltage at the branching circuit 53 with a predefined sampling frequency. For example, the voltage meter is electrically connected to the busbar for measuring the voltage at the busbar.

The sampling frequency of the voltage meter 66 is between 1 Hz and 10 kHz, in particular between 10 Hz and 500 Hz, for example substantially equal to 100 Hz.

According to embodiments, each meter 40, 54, 56, 58, 60, 66 comprises the same sampling frequency between 1 Hz and 10 kHz, in particular between 10 Hz and 500 Hz. For example, each measured value is associated with a measurement time or a specific sample. In particular, the meters 40, 54, 56, 58, 60, 66, and in particular their clocks, are synchronized. Further, the DC substation 10 includes a controller 68.

The controller 68 is adapted to receive measured values from the AC electricity meter 40, each determination device 54, 56, 58, 60 which is present according to the embodiment, and the voltage meter 66. In particular, the controller 68 is adapted to receive a measured energy from the AC electricity meter 40, a measured direct current from each determination device 54, 56, 58, 60 present according to the corresponding embodiment, and a measured voltage from the voltage meter 66.

Further, the controller 68 is adapted to determine for each branch the respective electrical energy consumption or production based on the received voltages, currents and energy.

The controller 68 is for example a computer comprising components known as such, for example a memory and a processor.

Alternative embodiments of the DC substation 10 are possible. For example, at least one branch 48, 50, 52 may comprise a plurality of sub-branches, wherein each sub-branch is adapted to connect to the DC substation 10 respectively at terminal 22, 24, 26 and to a load. In this example, a determination device like the determination devices 54, 56, 58, 60 is provided respectively for each sub-branch for determining the direct current in each sub-branch. Also, for example, an additional voltage meter is provided for measuring the voltage at the respective terminal 22, 24, 26.

A method for detecting an electrical energy flow in the DC substation 10 will now be described.

The first terminal 20 transmits or receives electrical power from or to the AC electrical power grid 12. Each terminal of the plurality of second terminals 22, 24, 26 transmits or receives electrical power from or to a respective load 12, 14, 16.

According to a first step of the method, the voltage meter 66 measures of a voltage of the branching circuit 53 over the time. In particular, the voltage meter 66 measures a voltage of the busbar. Each voltage measurement is for example associated with a measurement time. The controller 68 receives the voltage measurements.

According to a next step, each determining device 54, 56, 58 determines the direct current of the corresponding branch 48, 50, 52 over the time. Each current measurement is for example associated with a measurement time.

According to one embodiment, the current of one branch X cannot be determined, wherein the branch X is one of the branches 48, 50, 52. For example, no determination device is provided to the branch X. If the current of one branch X cannot be determined, the direct current between the current supply chain 30 and the branching circuit 53 is measured, for example by the determination device 60.

The controller 68 receives the measured currents of each determination device 54, 56, 58, 60.

According to a next step, the controller 68 computes the transmitted electrical power of each branch 48, 50, 52. In particular, the electrical power Pᵢ of a branch i is computed according to the formula Pᵢ=U·Iᵢ, wherein Iᵢ is the measured direct current of the corresponding branch 48, 50, 52.

If the power of the branch X of the branches 48, 50, 52 cannot be determined, the controller 68 computes the power Pₓ of this branch X according to the following formula: Pₓ=U·(Iₜₒₜₐₗ- ∑I_{i...N}), wherein Iₜₒₜₐₗ is the direct current measured by the determination device 60 and ∑I_{i...N} is the sum of the direct currents measured by the determination devices 54, 56, 58 of the branches 48, 50, 52 except branch X.

Further, the controller 68 calculates the energy flow of each branch by integrating the electrical power Pᵢ over the respective time interval for each branch 48, 50, 52. The calculated energy flow of a branch 48, 50, 52 may be positive or negative, according to the predominant energy flow direction in the corresponding branch 48, 50, 52. For example, the positive direction is defined as an energy flow direction from the AC electrical power grid 12 towards the loads 14, 16, 18, and a negative energy flow direction is defined as an energy flow direction from the loads 14, 16, 18 towards the AC electrical power grid 12.

According to a next step, the controller 68 determines a percentage of the energy flow of each branch 48, 50, 52 of a total energy flow of the branching circuit 53, notably based on the measurements of each determination device 54, 56, 58, 60. The percentage may be positive or negative, according to the predominant energy flow direction in the corresponding branch 48, 50, 52.

According to a next step or parallel to the previous step, the AC electricity meter 40 measures an electrical energy consumed or produced by the DC substation 10 over the time. Preferably, this step is executed simultaneously with the measurement of the direct currents and the voltage. Each electrical energy measurement is for example associated with a measurement time. In other words, the same time interval, sampling frequency for determining the energy flow at the AC electricity meter 40, the determination devices 54, 56, 58 and the voltage meter 66 are used for determining the relative energy flow in each of the branches 48, 50 ,52.

According to a final step, the controller 68 determines for each branch 48, 50, 52 the respective electrical energy consumption or production, based on the measured voltage, the measured currents and the electrical energy. In particular, the controller 68 multiplies the electrical energy measured by the AC electricity meter 40 with the percentages of the energy flow of each branch 48, 50, 52. The determined electrical energy consumption or production comprises pro rata the electrical losses of the current supply chain 30.

The DC substation 10 has a simple architecture and is easy to control at the same time.

The controller 68 allows detecting the energy flow in the DC substation 10 in a reliable way, by using the measurements of voltages, currents and electrical energy.

In particular, the fact that the controller 68 is able to determine the electrical energy consumption or production of each respective branch allows, for example, a billing according to the consumed or produced energy over the time separately for each branch 48, 50, 52. More generally, the controller 68 allows to determine the consumed or produced energy over the time separately for each branch 48, 50, 52.

For example, the energy prices may vary in function of the type of the load 14, 16, 18 connected to the respective second terminals 22, 24, 26. A distinction of the consumed or produced energy per branch 48, 50, 52 is thus obtained thanks to the DC substation 10.

Furthermore, the DC substation 10 allows to take into account the electrical losses of the rectifier line proportionally for each branch 48, 50, 52 to the consumed or produced energy of the corresponding branch 48, 50, 52.

In addition, the DC substation 10 is simple as no certified DC meter needs to be developed for the DC substation 10.

## Claims

1. DC substation (10) comprising:
- a first terminal (20) adapted to connect the DC substation (10) to an AC electrical power grid (12);
- a plurality of second terminals (22, 24, 26) adapted to provide or receive DC current to or from a respective load (14, 16, 18);
- a current supply chain (30) comprising an AC electricity meter (40), an AC/DC converter (44), and a branching circuit (53), the AC/DC converter (44) being electrically connected to the first terminal (20), the AC electricity meter (40) being connected in series with the AC/DC converter (44), wherein the AC electricity meter (40) is configured for measuring an electrical energy, and the branching circuit (53) providing respectively one branch (48, 50, 52) for each second terminal (22, 24, 26), each branch (48, 50, 52) being connected to a DC terminal (46) of the AC/DC converter (44);
- a plurality of determination devices (54, 56, 58, 60);
the DC substation (10) being **characterized in that**:
- each branch comprises a determination device (54, 56, 58) for determining a direct current in the respective branch (48, 50, 52), or
- each branch except one is provided with a determination device (54, 56, 58) for determining a direct current at least in each branch (48, 50, 52) except one and a determination device (60) is provided to measure the direct current between the branching circuit (53) and the AC/DC converter (44);
the DC substation (10) further comprising:
- a voltage meter (66) for determining the voltage at the branching circuit (53);
- a controller (68) adapted to receive the measured values from the AC electricity meter (40), each determination device (54, 56, 58, 60) and the voltage meter (66) and to determine, for each branch (48, 50, 52), the respective electrical energy consumption or production based on the received voltages, currents and electrical energy.

2. DC substation (10) according to claim 1, wherein the AC electricity meter (40) is configured for measuring the electrical energy with a predefined sampling frequency, the plurality of determination devices (54, 56, 58, 60) being configured for determining the direct current with the predefined sampling frequency, and the voltage meter (66) being configured for determining the voltage at the branching circuit (53) with the predefined sampling frequency.

3. DC substation (10) according to claim 1 or 2, wherein each determination device (54, 56, 58) comprises a DC meter electrically connected to the respective branch (48, 50, 52).

4. DC substation (10) according to any of the preceding claims, wherein one of the determination devices (60) comprises a DC meter electrically connected to the DC terminal (46) within the current supply chain (30).

5. DC substation (10) according to any of the preceding claims, wherein the branching circuit (53) comprises a busbar from which the respective branches (48, 50, 52) extend, wherein the voltage meter (66) is adapted to measure the voltage at the busbar.

6. DC substation (10) according to any of the preceding claims, wherein the load (14, 16, 18) is an electric road vehicle charging station, an energy storage system or a supply conductor for an electrical vehicle, the electrical vehicle being in particular a metro, tram, light rail, trolley bus, lorry, or the like.

7. DC substation (10) according to any of the preceding claims, wherein the controller (68) is configured for calculating the percentage of a total energy flow for each branch (48, 50, 52), based on the measurements of each determination device (54, 56, 58, 60).

8. DC substation (10) according to any of the preceding claims, wherein at least one of the determination devices (54, 56, 58, 60) is using state variables from a second control system distinct from the DC substation (10).

9. DC substation (10) according to any of the preceding claims, wherein at least one branch (48, 50, 52) comprises a DC/DC converter (62, 64).

10. Method for detecting an electrical energy flow in a DC substation (10), the DC substation (10) comprising:
- a first terminal (20) adapted to connect the DC substation (10) to an AC electrical power grid (12);
- a plurality of second terminals (22, 24, 26) adapted to provide or receive DC current to or from a load (14, 16, 18);
- a current supply chain (30) comprising an AC electricity meter (40), an AC/DC converter (44) and a branching circuit (53), the AC/DC converter (44) being electrically connected to the first terminal (20), the branching circuit (53) providing respectively one branch (48, 50, 52) for each second terminal (22, 24, 26), each branch (48, 50, 52) being connected to a DC terminal (46) of the AC/DC converter (44), the AC electricity meter (40) being connected in series with the AC/DC converter (44), wherein the AC electricity meter (40) is configured for measuring an electrical energy, the method comprising the steps of:
- measurement of a voltage at the branching circuit (53);
- determining, by a determination device (54, 56, 58) of each branch (48, 50, 52), the direct current of the respective branch (48, 50, 52), or determining the direct current in at least each branch (48, 50, 52) except one and measuring the direct current between the branching circuit (53) and the AC/DC converter (44);
- determining an electrical energy by the AC electricity meter (40);
- calculation of an electrical energy consumption or production of each branch (48, 50, 52), based on the measured voltage, the measured currents and the electrical energy.

11. Method according to claim 10, wherein the method further comprises a step of determining a percentage of a total energy flow of each branch (48, 50, 52) based on the measurements of each determination device (54, 56 ,58, 60).

## Patentansprüche

1. Gleichstrom-Unterstation (10), umfassend:
- einen ersten Anschluss (20), der angepasst ist, um die Gleichstrom-Unterstation (10) mit einem Wechselstromnetz (12) zu verbinden;
- eine Vielzahl von zweiten Anschlüssen (22, 24, 26), die angepasst sind, um Gleichstrom an eine jeweilige Last (14, 16, 18) bereitzustellen oder davon zu empfangen;
- eine Stromversorgungskette (30), umfassend einen Wechselstromzähler (40), einen AC/DC-Wandler (44) und eine Verzweigungsschaltung (53), wobei der AC/DC-Wandler (44) elektrisch mit dem ersten Anschluss (20) verbunden ist, der Wechselstromzähler (40) in Reihe mit dem AC/DC-Wandler (44) geschaltet ist, wobei der Wechselstromzähler (40) zum Messen einer elektrischen Energie konfiguriert ist, und die Verzweigungsschaltung (53) jeweils einen Zweig (48, 50, 52) für jeden zweiten Anschluss (22, 24, 26) bereitstellt, wobei jeder Zweig (48, 50, 52) mit einem Gleichstromanschluss (46) des AC/DC-Wandlers (44) verbunden ist;
- eine Vielzahl von Bestimmungsvorrichtungen (54, 56, 58, 60);
wobei die Gleichstrom-Unterstation (10) **dadurch gekennzeichnet ist, dass**:
- jeder Zweig eine Bestimmungsvorrichtung (54, 56, 58) zum Bestimmen eines Gleichstroms in dem jeweiligen Zweig (48, 50, 52) umfasst, oder
- jeder Zweig mit Ausnahme von einem mit einer Bestimmungsvorrichtung (54, 56, 58) zum Bestimmen eines Gleichstroms mindestens in jedem Zweig (48, 50, 52) mit Ausnahme von einem versehen ist und eine Bestimmungsvorrichtung (60) zum Messen des Gleichstroms zwischen der Verzweigungsschaltung (53) und dem AC/DC-Wandler (44) bereitgestellt ist;
die Gleichstrom-Unterstation (10) ferner umfassend:
- einen Spannungsmesser (66) zum Bestimmen der Spannung an der Verzweigungsschaltung (53);
- eine Steuerung (68), die angepasst ist, um die Messwerte von dem Wechselstromzähler (40), jeder Bestimmungsvorrichtung (54, 56, 58, 60) und dem Spannungsmesser (66) zu empfangen und für jeden Zweig (48, 50, 52) den jeweiligen elektrischen Energieverbrauch oder die Erzeugung basierend auf den empfangenen Spannungen, Strömen und der elektrischen Energie zu bestimmen.

2. Gleichstrom-Unterstation (10) nach Anspruch 1, wobei der Wechselstromzähler (40) zum Messen der elektrischen Energie mit einer vordefinierten Abtastfrequenz konfiguriert ist, die Vielzahl von Bestimmungsvorrichtungen (54, 56, 58, 60) zum Bestimmen des Gleichstroms mit der vordefinierten Abtastfrequenz konfiguriert ist, und der Spannungszähler (66) zum Bestimmen der Spannung an der Verzweigungsschaltung (53) mit der vordefinierten Abtastfrequenz konfiguriert ist.

3. Gleichstrom-Unterstation (10) nach Anspruch 1 oder 2, wobei jede Bestimmungsvorrichtung (54, 56, 58) einen Gleichstromzähler umfasst, der elektrisch mit dem jeweiligen Zweig (48, 50, 52) verbunden ist.

4. Gleichstrom-Unterstation (10) nach einem der vorherigen Ansprüche, wobei eine der Bestimmungsvorrichtungen (60) einen Gleichstromzähler umfasst, der elektrisch mit dem Gleichstromanschluss (46) innerhalb der Stromversorgungskette (30) verbunden ist.

5. Gleichstrom-Unterstation (10) nach einem der vorherigen Ansprüche, wobei der Verzweigungsschaltung (53) eine Sammelschiene umfasst, von der sich die jeweiligen Verzweigungen (48, 50, 52) erstrecken, wobei der Spannungsmesser (66) angepasst ist, um die Spannung an der Sammelschiene zu messen.

6. Gleichstrom-Unterstation (10) nach einem der vorherigen Ansprüche, wobei die Last (14, 16, 18) eine Elektrostraßenfahrzeug-Ladestation, ein Energiespeichersystem oder ein Versorgungsleiter für ein Elektrofahrzeug ist, wobei das Elektrofahrzeug insbesondere eine U-Bahn, eine Straßenbahn, eine Stadtbahn, ein Oberleitungsbus, ein Lastkraftwagen oder dergleichen ist.

7. Gleichstrom-Unterstation (10) nach einem der vorherigen Ansprüche, wobei die Steuerung (68) konfiguriert ist, um den Prozentsatz eines Gesamtenergieflusses für jeden Zweig (48, 50, 52) basierend auf den Messungen von jeder Bestimmungsvorrichtung (54, 56, 58, 60) zu berechnen.

8. Gleichstrom-Unterstation (10) nach einem der vorherigen Ansprüche, wobei mindestens eine der Bestimmungsvorrichtungen (54, 56, 58, 60) Zustandsvariablen von einem zweiten Steuersystem verwendet, das sich von der Gleichstrom-Unterstation (10) unterscheidet.

9. Gleichstrom-Unterstation (10) nach einem der vorherigen Ansprüche, wobei mindestens ein Zweig (48, 50, 52) einen DC/DC-Wandler (62, 64) umfasst.

10. Verfahren zum Erfassen eines elektrischen Energieflusses in einer Gleichstrom-Unterstation (10), die Gleichstrom-Unterstation (10) umfassend:
- einen ersten Anschluss (20), der angepasst ist, um die Gleichstrom-Unterstation (10) mit einem Wechselstromnetz (12) zu verbinden;
- eine Vielzahl von zweiten Anschlüssen (22, 24, 26), die angepasst sind, um Gleichstrom an eine Last (14, 16, 18) bereitzustellen oder davon zu empfangen;
- eine Stromversorgungskette (30), umfassend einen Wechselstromzähler (40), einen AC/DC-Wandler (44) und eine Verzweigungsschaltung (53), wobei der AC/DC-Wandler (44) elektrisch mit dem ersten Anschluss (20) verbunden ist, wobei die Verzweigungsschaltung (53) jeweils einen Zweig (48, 50, 52) für jeden zweiten Anschluss (22, 24, 26) bereitstellt, wobei jeder Zweig (48, 50, 52) mit einem Gleichstromanschluss (46) des AC/DC-Wandlers (44) verbunden ist, der Wechselstrom-Elektrizitätszähler (40) in Reihe mit dem AC/DC-Wandler (44) geschaltet ist, wobei der Wechselstromzähler (40) zum Messen einer elektrischen Energie konfiguriert ist, das Verfahren umfassend die folgenden Schritte:
- Messen einer Spannung an der Verzweigungsschaltung (53);
- Bestimmen, durch eine Bestimmungsvorrichtung (54, 56, 58) von jedem Zweig (48, 50, 52), des Gleichstroms des jeweiligen Zweigs (48, 50, 52), oder Bestimmen des Gleichstroms in mindestens jedem Zweig (48, 50, 52) mit Ausnahme von einem und Messen des Gleichstroms zwischen der Verzweigungsschaltung (53) und dem AC/DC-Wandler (44);
- Bestimmen einer elektrischen Energie durch den Wechselstromzähler (40);
- Berechnen des Verbrauchs oder der Erzeugung elektrischer Energie für jeden Zweig (48, 50, 52) basierend auf der gemessenen Spannung, den gemessenen Strömen und der elektrischen Energie.

11. Verfahren nach Anspruch 10, wobei das Verfahren ferner einen Schritt eines Bestimmens eines Prozentsatzes eines Gesamtenergieflusses von jedem Zweig (48, 50, 52) basierend auf den Messungen jeder Bestimmungsvorrichtung (54, 56, 58, 60) umfasst.

## Revendications

1. Sous-station CC (10) comprenant :
- une première borne (20) adaptée pour connecter la sous-station CC (10) à un réseau électrique CA (12) ;
- une pluralité de secondes bornes (22, 24, 26) adaptées pour fournir ou recevoir un courant continu vers ou depuis une charge respective (14, 16, 18) ;
- une chaîne d'alimentation en courant (30) comprenant un compteur d'électricité CA (40), un convertisseur CA/CC (44), et un circuit de dérivation (53), le convertisseur CA/CC (44) étant connecté électriquement à la première borne (20), le compteur d'électricité CA (40) étant connecté en série avec le convertisseur CA/CC (44), dans lequel le compteur d'électricité CA (40) est configuré pour mesurer une énergie électrique, et le circuit de dérivation (53) fournissant respectivement une dérivation (48, 50, 52) pour chaque seconde borne (22, 24, 26), chaque dérivation (48, 50, 52) étant connectée à une borne CC (46) du convertisseur CA/CC (44) ;
- une pluralité de dispositifs de détermination (54, 56, 58, 60) ;
la sous-station CC (10) étant **caractérisée en ce que** :
- chaque dérivation comprend un dispositif de détermination (54, 56, 58) pour déterminer un courant continu dans la dérivation respective (48, 50, 52), ou
- chaque dérivation sauf une est pourvue d'un dispositif de détermination (54, 56, 58) pour déterminer un courant continu au moins dans chaque dérivation (48, 50, 52) sauf une et un dispositif de détermination (60) est prévu pour mesurer le courant continu entre le circuit de dérivation (53) et le convertisseur CA/CC (44) ;
la sous-station CC (10) comprenant en outre :
- un voltmètre (66) pour déterminer la tension au niveau du circuit de dérivation (53) ;
- un contrôleur (68) adapté pour recevoir les valeurs mesurées du compteur d'électricité CA (40), de chaque dispositif de détermination (54, 56, 58, 60) et du voltmètre (66) et pour déterminer, pour chaque dérivation (48, 50, 52), la consommation ou la production d'énergie électrique respective sur la base des tensions, courants et énergie électrique reçus.

2. Sous-station CC (10) selon la revendication 1, dans laquelle le compteur d'électricité CA (40) est configuré pour mesurer l'énergie électrique avec une fréquence d'échantillonnage prédéfinie, la pluralité de dispositifs de détermination (54, 56, 58, 60) étant configurée pour déterminer le courant continu avec la fréquence d'échantillonnage prédéfinie, et le voltmètre (66) étant configuré pour déterminer la tension au niveau du circuit de dérivation (53) avec la fréquence d'échantillonnage prédéfinie.

3. Sous-station CC (10) selon la revendication 1 ou 2, dans laquelle chaque dispositif de détermination (54, 56, 58) comprend un compteur CC connecté électriquement à la dérivation respective (48, 50, 52).

4. Sous-station CC (10) selon l'une quelconque des revendications précédentes, dans laquelle l'un des dispositifs de détermination (60) comprend un compteur CC connecté électriquement à la borne CC (46) dans la chaîne d'alimentation en courant (30).

5. Sous-station CC (10) selon l'une quelconque des revendications précédentes, dans laquelle le circuit de dérivation (53) comprend une barre omnibus à partir de laquelle s'étendent les dérivations respectives (48, 50, 52), dans laquelle le voltmètre (66) est adapté pour mesurer la tension au niveau de la barre omnibus.

6. Sous-station CC (10) selon l'une quelconque des revendications précédentes, dans lequel la charge (14, 16, 18) est une station de charge de véhicule routier électrique, un système de stockage d'énergie ou un conducteur d'alimentation pour un véhicule électrique, le véhicule électrique étant en particulier un métro, un tramway, un métro léger, un trolleybus, un camion, ou l'équivalent.

7. Sous-station CC (10) selon l'une quelconque des revendications précédentes, dans laquelle le contrôleur (68) est configuré pour calculer le pourcentage d'un flux d'énergie total pour chaque dérivation (48, 50, 52), sur la base des mesures de chaque dispositif de détermination (54, 56, 58, 60).

8. Sous-station CC (10) selon l'une quelconque des revendications précédentes, dans laquelle au moins l'un des dispositifs de détermination (54, 56, 58, 60) utilise des variables d'état provenant d'un second système de commande distinct de la sous-station CC (10).

9. Sous-station CC (10) selon l'une quelconque des revendications précédentes, dans laquelle au moins une dérivation (48, 50, 52) comprend un convertisseur CC/CC (62, 64).

10. Procédé pour détecter un flux d'énergie électrique dans une sous-station CC (10), la sous-station CC (10) comprenant :
- une première borne (20) adaptée pour connecter la sous-station CC (10) à un réseau électrique CA (12) ;
- une pluralité de secondes bornes (22, 24, 26) adaptées pour fournir ou recevoir un courant continu vers ou depuis une charge (14, 16, 18) ;
- une chaîne d'alimentation en courant (30) comprenant un compteur d'électricité CA (40), un convertisseur CA/CC (44) et un circuit de dérivation (53), le convertisseur CA/CC (44) étant connecté électriquement à la première borne (20), le circuit de dérivation (53) fournissant respectivement une dérivation (48, 50, 52) pour chaque seconde borne (22, 24, 26), chaque dérivation (48, 50, 52) étant connectée à une borne CC (46) du convertisseur CA/CC (44), le compteur d'électricité CA (40) étant connecté en série avec le convertisseur CA/CC (44), dans lequel le compteur d'électricité CA (40) est configuré pour mesurer une énergie électrique, le procédé comprenant les étapes consistant à :
- la mesure d'une tension au niveau du circuit de dérivation (53) ;
- la détermination, par un dispositif de détermination (54, 56, 58) de chaque dérivation (48, 50, 52), du courant continu de la dérivation respective (48, 50, 52), ou la détermination du courant continu dans au moins chaque branche (48, 50, 52) sauf une et la mesure du courant continu entre le circuit de dérivation (53) et le convertisseur CA/CC (44) ;
- la détermination d'une énergie électrique par le compteur d'électricité CA (40) ;
- le calcul d'une consommation ou production d'énergie électrique de chaque dérivation (48, 50, 52), sur la base de la tension mesurée, des courants mesurés et de l'énergie électrique.

11. Procédé selon la revendication 10, dans lequel le procédé comprend en outre une étape consistant à déterminer un pourcentage d'un flux d'énergie total de chaque dérivation (48, 50, 52) sur la base des mesures de chaque dispositif de détermination (54, 56, 58, 60).
